(19) Europäisches Patentamt / European Patent Office / Office européen des brevets

(11) **EP 3 960 698 B1**

(12) **FASCICULE DE BREVET EUROPEEN**

(45) Date de publication et mention
de la délivrance du brevet:
**05.07.2023   Bulletin 2023/27**

(21) Numéro de dépôt: **21191832.1**

(22) Date de dépôt: **18.08.2021**

(51) Classification Internationale des Brevets (IPC):
**B81C 1/00** *(2006.01)*      **B06B 1/02** *(2006.01)*

(52) Classification Coopérative des Brevets (CPC):
**B06B 1/0292; B81C 1/00158;** B81C 2201/0192

(54) **PROCÉDÉ DE TRANSFERT D'UNE COUCHE MINCE SUR UN SUBSTRAT RECEVEUR COMPORTANT DES CAVITÉS ET UNE RÉGION DÉPOURVUE DE CAVITÉS**

VERFAHREN ZUR ÜBERTRAGUNG EINER DÜNNSCHICHT AUF EIN AUFNAHMESUBSTRAT, DAS HOHLRÄUME UND EINEN BEREICH OHNE HOHLRÄUME UMFASST

METHOD FOR TRANSFERRING A THIN LAYER ONTO A RECEIVER SUBSTRATE COMPRISING CAVITIES AND A REGION FREE FROM CAVITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **25.08.2020   FR 2008660**

(43) Date de publication de la demande:
**02.03.2022   Bulletin 2022/09**

(73) Titulaire: **Commissariat à l'énergie atomique et aux énergies alternatives
75015 Paris (FR)**

(72) Inventeurs:
• **SALVETAT, Thierry
38054 GRENOBLE CEDEX 09 (FR)**
• **BERRE, Guillaume
38054 GRENOBLE CEDEX 09 (FR)**

(74) Mandataire: **Brevalex
Tour Trinity
1 Bis Esplanade de La Défense
CS 60347
92035 Paris La Défense Cedex (FR)**

(56) Documents cités:
**EP-A1- 3 678 169       WO-A1-2014/206737
WO-A1-2019/141952     FR-A1- 3 032 555**

• **CHANG-HAN YUN ET AL: "Fabrication of Silicon and Oxide Membranes Over Cavities Using Ion-Cut Layer Transfer", JOURNAL OF MICROELECTROMECHANICAL SYSTEMS, IEEE SERVICE CENTER, US, vol. 9, no. 4, 1 décembre 2000 (2000-12-01), XP011034603, ISSN: 1057-7157**

**Description**

**DOMAINE TECHNIQUE**

Le domaine de l'invention est celui de la conception de substrats contenant des cavités enterrées. L'invention concerne plus particulièrement le transfert d'une couche mince pour la suspendre sur des cavités initialement ouvertes et ainsi sceller ces cavités.

**TECHNIQUE ANTÉRIEURE**

La fabrication de cavités enterrées passe par la suspension d'une couche mince (de quelques nanomètres à quelques microns d'épaisseur) sur des cavités de tailles et géométries variables, de quelques microns pour des applications de type résonateur microélectromécanique à quelques centaines de microns pour des applications de type assemblage (*packaging*) microélectronique.

Le procédé le plus courant pour réaliser cette suspension est celui de l'amincissement d'un substrat de silicium ou encore d'un silicium sur isolant (SOI). D'autres procédés font appel à des technologies de collage, perçage d'un substrat et attaque chimique du substrat pour usiner les cavités. Ces techniques, bien que maîtrisées, sont problématiques en termes de coût (consommation complète d'un substrat Si ou pire d'un substrat SOI), de temps (procédé d'amincissement long) et d'épaisseur de couche mince.

La technologie Smart Cut™ est une technique largement développée depuis environ deux décennies pour permettre le transfert de couches minces de matériaux semiconducteurs. Selon cette technique, des espèces ioniques telles que de l'hydrogène et/ou de l'hélium sont implantées dans un substrat donneur afin d'y former un plan de fragilisation. Le substrat donneur est par la suite mis en contact avec un substrat support, par exemple par collage direct. Cette technique fait ensuite appel au développement des défauts générés au niveau du plan de fragilisation. Ce développement implique un apport énergétique, généralement réalisé au moyen d'un traitement thermique de quelques centaines de degrés, 500°C typiquement, pendant quelques dizaines de minutes. Cela conduit à la formation d'une couche confinée de microfissures au sein de laquelle va s'initier et se propager une fracture. Cette fracture sépare le substrat donneur le long du plan de fragilisation et une couche mince du substrat donneur est ainsi transférée sur le substrat support.

Lors du recuit de fracture du procédé Smart Cut™, l'espèce introduite au préalable par implantation ionique pour former le plan de fragilisation réagit et forme des défauts à une certaine profondeur dans le substrat donneur. Ces défauts sont pressurisés et de deux types dépendant de l'application ou non d'un effet raidisseur.

En présence d'un effet raidisseur, apporté par un substrat collé au substrat donneur ou par un dépôt épais sur celui-ci, les défauts se développent sous la forme de microfissures qui se propagent préférentiellement latéralement et peuvent atteindre des tailles de quelques centaines de microns.

En l'absence d'un effet raidisseur en revanche, la surface du substrat étant laissée libre, les défauts se développent sous la forme de cloques qui se propagent horizontalement et verticalement, leur croissance étant bornée par le phénomène d'exfoliation correspondant à leur décapsulation.

La publication de C-H Yun et N.W.Cheung, « Fabrication of Silicon and Oxide Membranes Over Cavities Using Ion-Cut Layer Transfer", Journal of Microelectromechanical Systems, vol. 9, no. 4, december 2000, montre qu'une membrane d'épaisseur donnée ne peut être transférée avec succès que sur des cavités dont la taille est inférieure à une taille limite. Cela est lié au fait que, dans la cavité, il n'y a pas d'effet raidisseur. Une cloque peut donc se développer en entraînant une déformation de la membrane, laquelle peut se briser (exfoliation) ce qui conduit à l'échec local du transfert.

La taille maximale des cloques, et donc la taille des exfoliations, est ainsi critique dans le procédé de transfert sur cavités car ce mode de croissance est présent dans les cavités lors du recuit de fracture. Ainsi, s'il y a une exfoliation avant le passage de la fracture, la cavité sera systématiquement percée. Par ailleurs, la Demanderesse a pu observer qu'à conditions d'implantation, de collage et de traitement thermique identiques, une fracturation et donc le transfert d'un film peuvent être obtenus avec un substrat receveur présentant une importante surface de collage avec le substrat donneur alors qu'aucune fracture ne peut être obtenue, y compris en augmentant le temps de traitement thermique, dans le cas où le substrat receveur est entièrement couvert de cavités et n'offre donc pour le collage avec le substrat donneur que l'espace inter-cavités présent entre les cavités et la région périphérique d'exclusion connue sous le nom de *wafer edge exclusion.*

WO 2014/206737 A1 (SOITEC SILICON ON INSULATOR [FR]) 31 décembre 2014 (2014-12-31) décrit un procédé de transfert d'une couche semi-conductrice d'un substrat donneur comprenant un plan de fragilisation vers un substrat receveur comprenant une face de collage qui présente des cavités ouvertes, comprenant la réalisation, par mise en contact du substrat donneur et de la face de collage du substrat receveur, d'un assemblage dans lequel lesdites cavités sont enterrées et la séparation de l'assemblage par fracture le long du plan de fragilisation.

**EXPOSÉ DE L'INVENTION**

L'invention a pour objectif de proposer une technique de scellement de cavités au moyen d'un report par Smart Cut™ d'une couche mince d'un substrat donneur sur un substrat receveur, le substrat receveur étant couvert de multiples cavités et présentant une surface de collage restreinte.

A cet effet, l'invention porte sur un procédé de transfert d'une couche semiconductrice d'un substrat donneur comprenant un plan de fragilisation vers un substrat receveur comprenant une face de collage qui présente des cavités ouvertes. Le procédé comprend la réalisation, par mise en contact du substrat donneur et de la face de collage du substrat receveur, d'un assemblage dans lequel lesdites cavités sont enterrées et la séparation de l'assemblage par fracture le long du plan de fragilisation. La face de collage du substrat receveur comporte en dehors des cavités ouvertes une surface de collage qui vient en contact avec le substrat donneur lors de la réalisation de l'assemblage. Cette surface de collage comprend une région dépourvue de cavités et un espace inter-cavités qui occupe de 15 à 50 % de la face de collage du substrat receveur.

L'invention porte également sur un substrat apte à permettre la mise en oeuvre du procédé, notamment un substrat comprenant une face de collage présentant des cavités ouvertes, destiné à servir de substrat receveur dans un procédé de transfert d'une couche semiconductrice d'un substrat donneur présentant un plan de fragilisation vers le substrat receveur, ledit procédé comprenant la réalisation, par mise en contact du substrat donneur et de la face de collage du substrat receveur, d'un assemblage dans lequel lesdites cavités sont enterrées et la séparation de l'assemblage par fracture le long du plan de fragilisation. La face de collage présente en dehors des cavités ouvertes une surface de collage qui vient en contact avec le substrat donneur lors de la réalisation de l'assemblage, ladite surface de collage comprenant une région dépourvue de cavités et un espace inter-cavités qui occupe de 15 à 50 % de la face du substrat receveur.

Dans un procédé ou un substrat selon l'invention, ladite région dépourvue de cavités :

- a une dimension d'au moins 100 $\mu$m et présente une surface d'au moins 1 mm$^2$;
- peut être disposée en bordure de la face de collage du substrat receveur, ou dans une partie de cette face de collage qui n'est pas en bordure (par exemple elle est au centre de cette face).

Certains aspects préférés mais non limitatifs d'un procédé ou d'un substrat selon l'invention sont les suivants, qui peuvent être combinés entre eux :

- ladite région dépourvue de cavités est disposée en bordure de la face de collage du substrat receveur et prend la forme d'une portion d'anneau en bordure de cette face de collage;
- l'espace inter-cavités occupe de 20 à 40% de la face de collage du substrat receveur;
- une dimension caractéristique des cavités est inférieure ou égale à un rayon moyen d'exfoliation déterminé par analyse statistique d'observations microscopiques d'arrachements localisés de la surface du substrat donneur soumis à un traitement thermique de fracturation ;
- la dimension caractéristique des cavités est inférieure ou égale à un rayon minimum d'exfoliation déterminé par ladite analyse statistique ;
- une distance de séparation entre cavités contiguës est telle que la somme de la dimension caractéristique des cavités et de ladite distance de séparation est inférieure à 100 $\mu$m ;
- ladite distance de séparation est supérieure à 1 $\mu$m ;
- le substrat receveur présente un bord chanfreiné et, si la région dépourvue de cavités est en bordure de la face de collage, cette région débouche sur ledit bord chanfreiné ;
- le substrat receveur est dépourvu de bord chanfreiné et, si la région dépourvue de cavités est en bordure de la face de collage, cette région est présente le long du bord du substrat receveur.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

[Fig. 1] la figure 1 est un schéma illustrant les différentes étapes d'un procédé selon l'invention ;
[Fig. 2] la figure 2 est un schéma d'un substrat receveur conforme à un exemple de mise en oeuvre de l'invention ;
[Fig. 3] la figure 3 est un schéma d'un autre substrat receveur conforme à un exemple de mise en œuvre de l'invention ;
[Fig. 4] la figure 4 illustre une observation microscopique d'arrachements localisés de la surface du substrat donneur soumis à un traitement thermique de fracturation sans effet raidisseur ;
[Fig. 5] la figure 5 représente un rayon d'exfoliation en fonction de la profondeur d'implantation tel que déterminé au moyen d'une observation microscopique du type de celle de la figure 4.

## EXPOSÉ DÉTAILLÉ DE MODES DE RÉALISATION PARTICULIERS

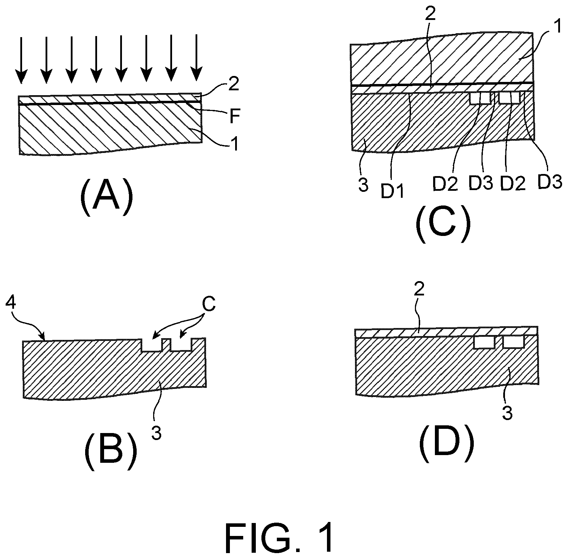

En référence à la figure 1, l'invention porte un substrat receveur destiné à être utilisé dans un procédé de transfert d'une couche semiconductrice 2 d'un substrat donneur 1 vers un substrat receveur 3.
Une face 4 du substrat receveur 3, dite face de collage, comporte une pluralité de cavités ouvertes C, par exemple issues de gravure, qui peuvent potentiellement présenter des tailles et/ou des géométries différentes. Les cavités peuvent par exemple être de géométrie carrée, rectangulaire, circulaire ou triangulaire.

Le transfert de la couche semiconductrice 2 sur la face de collage 4 du substrat receveur vise à sceller tout ou partie de ces cavités. De sorte que l'invention trouve application à la fabrication de tout type de dispositif s'appuyant sur l'utilisation d'une membrane suspendue, comme par exemple les transducteurs ultrasoniques micro-usinés de type capacitif (cMUT pour « capacitive Micromachined Ultrasonic Transducers »).

L'invention porte également sur un procédé de transfert exploitant un tel substrat receveur, la couche semiconductrice 2 pouvant être une couche de silicium, de phosphure d'indium, de germanium, de tantalate de lithium ou d'arséniure de gallium

Le procédé selon l'invention comprend une étape (A) de formation d'un plan de fragilisation F dans l'épaisseur du substrat donneur 1 au moyen d'une implantation d'espèces ioniques, par exemple de l'hydrogène et/ou de l'hélium. Ce plan de fragilisation F délimite une portion superficielle du substrat donneur qui va former la couche mince à transférer 2 d'une partie massive du substrat donneur.

Le substrat donneur 1 peut être recouvert d'une couche préalablement déposée sur celui-ci, par exemple une couche diélectrique ou une couche contrainte. Le substrat donneur 1 peut également comprendre une structure multicouche, par exemple une structure multicouche multi-matériaux (par exemple un dépôt d'oxyde ou de nitrure de silicium, des dépôts métalliques fins ou d'autre dépôts fonctionnels). Ces dépôts peuvent être réalisés avant l'implantation ionique (tout en restant compatibles avec celle-ci) ou après l'implantation ionique (dans ce cas, ils ne doivent pas faire appel à des budgets thermiques pouvant entraîner la maturation des défauts au niveau de la zone implantée ; ils sont ainsi typiquement réalisés à une température inférieure à 400°C, préférentiellement inférieure ou égale à 350°C).

Le procédé comprend une étape (B) de fourniture du substrat receveur 3 dont la représentation sur la figure 1 est purement illustrative.

Le procédé comprend ensuite une étape de réalisation (C), par mise en contact du substrat donneur 1 et de la face de collage 4 du substrat receveur 3, d'un assemblage dans lequel tout ou partie des cavités sont enterrées. La mise en contact des substrats 1,3 est ainsi réalisée de telle manière que la couche mince 2 vienne sceller tout ou partie des cavités.

Le procédé comprend ensuite une étape de séparation de l'assemblage (D) par fracture le long du plan de fragilisation F. Cette séparation est obtenue au moyen d'un apport énergétique, généralement réalisé au moyen d'un traitement thermique. Cette séparation conduit au transfert de la couche mince 2 du substrat donneur 1 vers le substrat receveur 3.

Dans le cadre de ses recherches sur l'application de la technologie Smart Cut™ au scellement de cavités micrométriques, la Demanderesse a pu constater que la maturation des défauts à proximité des cavités est ralentie voire inhibée. Elle a également pu observer, selon les conditions d'implantation et la taille des cavités, la formation de cloques dans les cavités pouvant venir jusqu'à remplir complètement les cavités. Ces différents types de défauts sont illustrés sur la figure 1 où D1 représente une région au niveau de laquelle des microfissures se développent de manière conventionnelle, où D2 représente une région au niveau de laquelle des cloques se développent dans les cavités et où D3 représente une région au niveau de laquelle la croissance des microfissures est ralentie voire inhibée du fait de la proximité des cavités.

L'idée à la base de la présente invention est de disposer d'un substrat receveur, certes majoritairement doté de cavités, mais qui présente une surface suffisante pour assurer la génération et la croissance de microfissures du type D1 et initier ainsi la fracture à une position choisie.

Pour ce faire, selon un exemple de mise en oeuvre de l'invention, en dehors des cavités ouvertes la face de collage 4 du substrat receveur comporte (de préférence consiste en) une surface de collage qui vient en contact avec le substrat donneur lors de l'étape (B) de réalisation de l'assemblage, ladite surface de collage comprenant (de préférence consistant en) au moins une région dépourvue de cavités en bordure de la face de collage du substrat receveur et un espace inter-cavités (correspondant à l'ensemble des surfaces horizontales des murets séparant les cavités et excluant la région dépourvue de cavités en bordure) qui occupe de 15 à 50 % de la face du substrat receveur.

Le substrat receveur est ainsi principalement couvert de cavités, la surface de collage permettant néanmoins d'assurer l'apparition et la croissance de microfissures et d'initier la fracture à une position choisie, en l'occurrence au niveau de la bordure de la face de collage.

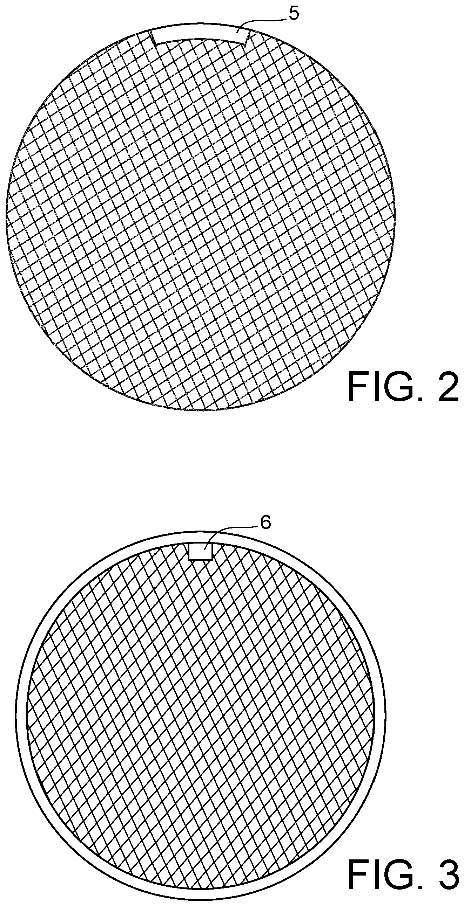

Les figures 2 et 3 représentent des réalisations de substrats receveurs conformes à cet exemple de mise en oeuvre de l'invention. Le bord de plaque chanfreiné du substrat receveur de la figure 2 a fait l'objet d'un détourage tandis que le bord de plaque chanfreiné 7 du substrat receveur de la figure 3 n'a pas fait l'objet d'un détourage. Dans un cas comme dans l'autre, le substrat receveur comprend une région dépourvue de cavités 5, 6 en bordure de la face de collage du substrat receveur. Cette région est en ainsi présente le long du bord du substrat sur la figure 2, tandis qu'elle débouche sur le bord chanfreiné du substrat sur la figure 3, lequel bord chanfreiné ne fait pas partie de la face de collage du substrat receveur mise en contact avec le substrat donneur à l'étape (C). Ainsi, dans l'invention, par bordure de la face de collage on entend la région périphérique extérieure de la face de collage (i.e. son pourtour) qui vient en contact avec le substrat donneur lors de l'étape (C). Le reste de la face de collage de chacun des substrats receveurs des figures 2 et 3 est occupé par des cavités qui sont ici de dimensions et d'espacement essentiellement constants.

L'initiation de la fracture étant un évènement statistique essentiellement aléatoire, plus la surface de la région dépourvue de cavités de la face de collage (par exemple en bordure de celle-ci comme expliqué ci-dessus) du substrat receveur est importante et plus le déclenchement de la fracture a une probabilité de survenir dans cette région dépourvue de cavités. On prévoit ainsi que cette région dépourvue de cavités présente une surface d'au moins 1 mm², de préférence d'au moins 3 mm², encore de préférence d'au moins 5 mm², par exemple de 6 mm².

La région dépourvue de cavités, par exemple en bordure de la face de collage, présente de préférence des dimensions, mesurées dans un plan parallèle à la face de collage, dont la plus petite est supérieure ou égale à 100 μm.

Comme représenté sur les figures 2 et 3, une région 5, 6 dépourvue de cavités, dans le cas où elle est en bordure de la face de collage du substrat receveur, peut prendre la forme d'une portion d'anneau. Lorsque cette région prend la forme d'une portion d'anneau, c'est par exemple sa dimension radiale (i.e. son épaisseur) qui en forme la dimension le plus petite et qui est ainsi de préférence supérieure ou égale à 100 μm. La dimension circonférentielle de la portion d'anneau (i.e. sa longueur annulaire) est quant à elle de préférence d'au plus un quart du périmètre du substrat receveur.

Comme expliqué ci-dessus, la région dépourvue de cavités et la zone d'initiation peuvent être disposées en périphérie de la face de collage du substrat receveur. Plus généralement, la région dépourvue de cavités, et donc la zone d'initiation, peuvent être en tout point de cette face de collage du substrat receveur; cette région dépourvue de cavités, mesurée dans le plan de cette face, est supérieure à 1mm² avec une plus petite dimension d'au moins 100μm dans ce même plan. Ainsi cette région dépourvue de cavités peut être au centre de la face de collage ou même dans une partie de la face de collage qui n'est pas en périphérie ou en bordure de celle-ci. Les autres aspects décrits ci-dessus trouvent à s'appliquer à cette réalisation plus générale.

Quelle que soit la réalisation envisagée (zone dépourvue de cavités en bordure, ou pas en bordure, de la face de collage), prenant l'exemple de cavités carrées de côté a séparées les unes des autres d'une distance b (largeur de la surface horizontale des murets rectilignes séparant les cavités), l'espace inter-cavités occupe globalement (i.e. sans prendre en compte la région périphérique d'exclusion du substrat receveur ni la région dépourvue de cavités) un pourcentage de la surface de la face de collage correspondant au ratio $\frac{(a+b)^2-a^2}{(a+b)^2}$. Pour assurer un collage efficace tout en laissant la fracture s'initier préférablement au niveau de la région dépourvue de cavité, ce ratio est de préférence compris entre 15 et 50%, encore plus de préférence entre 20 et 40%.

Pour éviter la rupture de la couche mince 2 lors de la maturation des défauts ou au passage de la fracture, les cavités présentent préférentiellement un dimensionnement adapté aux dimensions d'exfoliation du substrat donneur.

Le rayon d'exfoliation $R_{exfo}$ peut être défini selon l'équation suivante $R_{exfo} = \frac{64}{3} * \frac{(1-v^2)}{Ek_BT} * \frac{1}{\alpha * Dose} * \sigma_{crit}^2 * e^2$, avec u le coefficient de Poisson, E le module d'Young, $k_B$ la constante de Boltzman, T la température (K), α la fraction de dose efficace (%), Dose la dose implantée (at/cm²), $\sigma_{crit}$ la constante limite de cisaillement et e l'épaisseur de la couche mince. Ce rayon dépend donc de la dose implantée, de la température de traitement thermique et de l'épaisseur (donc de l'énergie d'implantation) mais également de grandeurs difficilement quantifiables comme la contrainte limite de cisaillement $\sigma_{crit}$. Il est par conséquent préférable de déterminer cette dimension expérimentalement en soumettant un substrat donneur implanté à un traitement thermique de type fracturation (par exemple 1h à 500°C dans le cas d'un substrat donneur en silicium). En l'absence d'un effet raidisseur, ce recuit entraine la formation de cloques (« blisters ») et d'arrachements localisés (exfoliations).

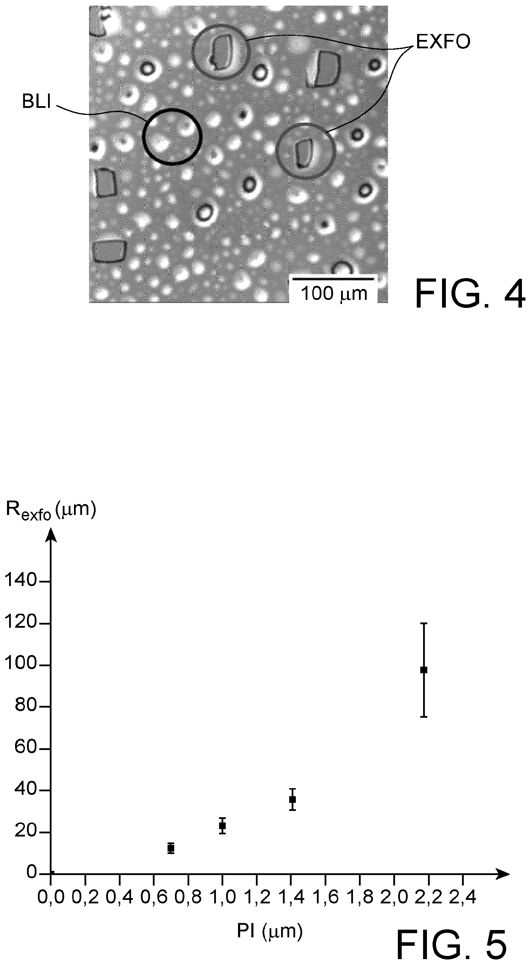

Comme représenté sur la figure 4, des observations en microscopie optique de la surface du substrat donneur permettent d'observer ces cloques BLI et ces exfoliations EXFO, ces dernières étant aisément repérables par la présence d'un liseré sombre sur leur contour. Une analyse d'image permet de mesurer la surface de ces exfoliations EXFO. Les surfaces ainsi mesurées sont converties en rayon (considérant les défauts comme circulaires). Les dimensions ainsi extraites, en nombre suffisant pour permettre une analyse statistique (i.e. typiquement une population de plusieurs dizaines d'exfoliations), permettent alors de définir leur taille minimum ($R_{min\ exfo}$), moyenne ($R_{avg\ exfo}$) et maximum ($R_{max\ exfo}$). La figure 5 illustre à cet égard le rayon $R_{exfo}$ des exfoliations observées selon ce protocole expérimental pour des substrats de silicium implantés à une dose fixe, en fonction de l'énergie d'implantation ici traduite en profondeur d'implantation PI.

On prévoit de préférence qu'une dimension caractéristique des cavités est égale au rayon moyen, avantageusement inférieure à celui-ci et plus avantageusement encore égale ou inférieure à un rayon minimum d'exfoliation $R_{min\ exfo}$ déterminé par analyse statistique d'observations microscopiques d'arrachements localisés de la surface du substrat donneur soumis à un traitement thermique de fracturation. Par exemple si ce rayon minimum est de 15 μm, les cavités peuvent avantageusement prendre la forme de carrés de 15×15 μm², des cercles de diamètre 15 μm ou des lignes de 15 μm

de largeur.

L'espace inter-cavités est quant à lui dimensionné de préférence de telle manière que la distance de séparation entre cavités contiguës soit telle que la somme de ladite dimension caractéristique et de ladite distance de séparation est inférieure à 100 $\mu$m, voire inférieure à 80 $\mu$m, voire encore inférieure à 50 $\mu$m. A l'inverse, cette distance de séparation est de préférence choisie suffisamment grande, typiquement supérieure à 1 $\mu$m, par exemple de l'ordre de 7 $\mu$m, pour permettre un collage efficace entre les deux substrats, en fonction de la méthode de collage envisagée.

Selon un exemple, les inventeurs ont pu initier la fracture au centre de la face de collage du substrat receveur avec, en ce centre, une zone dépourvue de cavités de 2mm*2mm (surface mesurée dans le plan de la face de collage), le reste de la tranche présentant des cavités de 20*20 $\mu$m$^2$ espacées de 7$\mu$m.

## Revendications

1. Procédé de transfert d'une couche semiconductrice (2) d'un substrat donneur (1) comprenant un plan de fragilisation (F) vers un substrat receveur (3) comprenant une face de collage (4) qui présente des cavités ouvertes (C), comprenant la réalisation, par mise en contact du substrat donneur et de la face de collage du substrat receveur, d'un assemblage dans lequel lesdites cavités sont enterrées et la séparation de l'assemblage par fracture le long du plan de fragilisation,
procédé dans lequel la face de collage du substrat receveur comporte en dehors des cavités ouvertes une surface de collage qui vient en contact avec le substrat donneur lors de la réalisation de l'assemblage, ladite surface de collage comprenant une région dépourvue de cavités (5, 6), dont une dimension est d'au moins 100 $\mu$m et qui présente une surface d'au moins 1 mm$^2$, et un espace inter-cavités qui occupe de 15 à 50 % de la face de collage du substrat receveur.

2. Procédé selon la revendication 1, dans lequel ladite région dépourvue de cavités (5, 6) est en bordure de la face de collage du substrat receveur.

3. Procédé selon la revendication 1, dans lequel ladite région dépourvue de cavités (5, 6) est au centre de la face de collage.

4. Procédé selon la revendication 2, dans lequel ladite région dépourvue de cavités (5, 6) prend la forme d'une portion d'anneau en bordure de la face de collage du substrat receveur.

5. Procédé selon l'une des revendications 1 à 4, dans lequel l'espace inter-cavités occupe de 20 à 40% de la face de collage du substrat receveur.

6. Procédé selon l'une des revendications 1 à 5, dans lequel une dimension caractéristique des cavités est inférieure ou égale à un rayon moyen d'exfoliation déterminé par analyse statistique d'observations microscopiques d'arrachements localisés de la surface du substrat donneur soumis à un traitement thermique de fracturation.

7. Procédé selon la revendication 6, dans lequel la dimension caractéristique des cavités est inférieure ou égale à un rayon minimum d'exfoliation déterminé par ladite analyse statistique.

8. Procédé selon l'une des revendications 6 et 7, dans lequel une distance de séparation entre cavités contiguës est telle que la somme de la dimension caractéristique des cavités et de ladite distance de séparation est inférieure à 100 $\mu$m.

9. Procédé selon la revendication 8, dans lequel ladite distance de séparation est supérieure à 1 $\mu$m.

10. Procédé selon la revendication 2, dans lequel le substrat receveur présente un bord chanfreiné et dans lequel la région dépourvue de cavités (5, 6) en bordure de la face de collage débouche sur ledit bord chanfreiné.

11. Procédé selon la revendication 2, dans lequel le substrat receveur est dépourvu de bord chanfreiné et dans lequel la région dépourvue de cavités (5, 6) en bordure de la face de collage est présente le long du bord du substrat receveur.

12. Substrat (3) comprenant une face de collage (4) présentant des cavités ouvertes (C), destiné à servir de substrat receveur dans un procédé de transfert d'une couche semiconductrice (2) d'un substrat donneur (1) présentant un plan de fragilisation (F) vers le substrat receveur, ledit procédé comprenant la réalisation, par mise en contact du substrat donneur et de la face de collage du substrat receveur, d'un assemblage dans lequel lesdites cavités sont enterrées et la séparation de l'assemblage par fracture le long du plan de fragilisation, la face de collage présentant en dehors des cavités ouvertes une surface de collage qui vient en contact avec le substrat donneur lors de la réalisation de l'assemblage, ladite surface de collage comprenant une région dépourvue de cavités (5, 6), dont une dimension est d'au moins 100 $\mu$m et qui présente une surface d'au moins 1 mm$^2$, et un espace inter-cavités qui occupe de 15 à 50 % de la face du substrat receveur.

13. Substrat selon la revendication 12, dans lequel ladite région dépourvue de cavités (5, 6) est en bordure de la face de collage du substrat receveur.

14. Substrat selon la revendication 12, dans lequel ladite région dépourvue de cavités (5, 6) est au centre de la face de collage du substrat receveur

15. Substrat selon l'une des revendications 12 à 14, dans lequel l'espace inter-cavités occupe de 20 à 40% de la face de collage du substrat receveur.

**Patentansprüche**

1. Verfahren zur Übertragung einer Halbleiterschicht (2) von einem Spendersubstrat (1), welches eine Schwächungsebene (F) umfasst, auf ein Empfängersubstrat (3), welches eine Klebefläche (4) umfasst, welche offene Hohlräume (C) aufweist, umfassend die Verwirklichung durch Kontaktanbahnung des Spendersubstrats und der Klebefläche des Empfängersubstrats, einer Zusammensetzung, in der die Hohlräume eingegraben sind, und die Trennung der Zusammensetzung durch Brechen entlang der Schwächungsebene,
Verfahren, wobei die Klebefläche des Empfängersubstrats außerhalb der offenen Hohlräume eine Klebeoberfläche beinhaltet, die bei der Verwirklichung der Zusammensetzung in Kontakt mit dem Spendersubstrat kommt, wobei die Klebeoberfläche eine Region umfasst, die mit keinen Hohlräumen (5, 6) versehen ist, von der eine Abmessung mindestens 100 $\mu$m beträgt, und die eine Oberfläche von mindestens 1 mm$^2$ aufweist, und einen Raum zwischen den Hohlräumen, der von 15 bis 50 % der Klebefläche des Empfängersubstrats einnimmt.

2. Verfahren nach Anspruch 1, wobei die Region, die mit keinen Hohlräumen (5, 6) versehen ist, am Rande der Klebefläche des Empfängersubstrats liegt.

3. Verfahren nach Anspruch 1, wobei die Region, die mit keinen Hohlräumen (5, 6) versehen ist, in der Mitte der Klebefläche liegt.

4. Verfahren nach Anspruch 2, wobei die Region, die mit keinen Hohlräumen (5, 6) versehen ist, die Form eines Ringabschnitts am Rande der Klebefläche des Empfängersubstrats annimmt.

5. Verfahren nach einem der Ansprüche 1 bis 4, wobei der Raum zwischen den Hohlräumen von 20 bis 40 % der Klebefläche des Empfängersubstrats einnimmt.

6. Verfahren nach einem der Ansprüche 1 bis 5, wobei eine charakteristische Abmessung der Hohlräume kleiner oder gleich einem mittleren Exfoliationsradius ist, der durch statistische Analyse von mikroskopischen Beobachtungen lokalisierter Ausbrüche aus der Oberfläche des Spendersubstrats bestimmt wird, welches einer Bruchwärmebehandlung ausgesetzt wird.

7. Verfahren nach Anspruch 6, wobei die charakteristische Abmessung der Hohlräume kleiner oder gleich einem Mindest-Exfoliationsradius ist, der durch die statistische Analyse bestimmt wird.

8. Verfahren nach einem der Ansprüche 6 und 7, wobei ein Trennungsabstand zwischen angrenzenden Hohlräumen derart ist, dass die Summe der charakteristischen Abmessung der Hohlräume und des Trennungsabstands kleiner als 100 $\mu$m ist.

9. Verfahren nach Anspruch 8, wobei der Trennungsabstand größer als 1 $\mu$m ist.

10. Verfahren nach Anspruch 2, wobei das Empfängersubstrat einen gefasten Rand aufweist, und wobei die Region, die mit keinen Hohlräumen (5, 6) versehen ist, am Rande der Klebefläche in den gefasten Rand einmündet.

11. Verfahren nach Anspruch 2, wobei das Empfängersubstrat mit keinem gefasten Rand versehen ist, und wobei die Region, die mit keinen Hohlräumen (5, 6) versehen ist, am Rande der Klebefläche entlang des Randes des Empfängersubstrats vorhanden ist.

12. Substrat (3), umfassend eine Klebefläche (4), die offene Hohlräume (C) aufweist, dazu bestimmt, als Empfängersubstrat in einem Verfahren zur Übertragung einer Halbleiterschicht (2) von einem Spendersubstrat (1), das eine Schwächungsebene (F) umfasst, auf ein Empfängersubstrat zu dienen, wobei das Verfahren die Verwirklichung durch Kontaktanbahnung des Spendersubstrats und der Klebefläche des Empfängersubstrats, einer Zusammensetzung, in der die Hohlräume eingegraben sind, und die Trennung der Zusammensetzung durch Bruch entlang der Schwächungsebene umfasst, wobei die Klebefläche außerhalb der offenen Hohlräume eine Klebeoberfläche aufweist, die bei der Verwirklichung der Zusammensetzung in Kontakt mit dem Spendersubstrat kommt, wobei die Klebeoberfläche eine Region umfasst, die mit keinen Hohlräumen (5, 6) versehen ist, von der eine Abmessung mindestens 100 $\mu$m beträgt, und die eine Oberfläche von mindestens 1 mm$^2$ aufweist, und einen Raum zwischen den Hohlräumen, der von 15 bis 50 % der Fläche des Empfängersubstrats einnimmt.

13. Substrat nach Anspruch 12, wobei die Region, die mit keinen Hohlräumen (5, 6) versehen ist, am Rande der Klebefläche des Empfängersubstrats liegt.

**14.** Substrat nach Anspruch 12, wobei die Region, die mit keinen Hohlräumen (5, 6) versehen ist, in der Mitte der Klebefläche des Empfängersubstrats liegt.

**15.** Substrat nach einem der Ansprüche 12 bis 14, wobei der Raum zwischen den Hohlräumen von 20 bis 40 % der Klebefläche des Empfängersubstrats einnimmt.

**Claims**

**1.** Method for transferring a semiconductor layer (2) from a donor substrate (1) comprising a weakening plane (F) to a receiver substrate (3) comprising a bonding face (4) that has open cavities (C), comprising the implementation, by putting the donor substrate and the bonding face of the receiver substrate in contact, of an assembly wherein said cavities are buried and the separation of the assembly by fracture alone the weakening plane,
in which method the bonding face of the receiver substrate includes, apart from the open cavities, a bonding surface that comes into contact with the donor substrate when the assembly is implemented, said bonding surface comprises a region devoid of cavities (5, 6), one dimension of which is at least 100 $\mu$m and which has a surface area of at least 1 mm$^2$, and an intercavity space that occupies from 15 to 50% of the bonding face of the receiver substrate.

**2.** Method according to claim 1, wherein said region devoid of cavities (5, 6) is at the rim of the bonding face of the receiver substrate.

**3.** Method according to claim 1, wherein said region devoid of cavities (5, 6) is at the centre of the bonding face.

**4.** Method according to claim 2, wherein said region devoid of cavities (5, 6) takes the form of a portion of a ring at the rim of the bonding face of the receiver substrate.

**5.** Method according to one of claims 1 to 4, wherein the intercavity space occupies from 20 to 40% of the bonding face of the receiver substrate.

**6.** Method according to one of claims 1 to 5, wherein a characteristic dimension of the cavities is less than or equal to a mean exfoliation radius determined by statistical analysis of microscopic observations of localised detachments of the surface of the donor substrate subjected to a fracturing heat treatment.

**7.** Method according to claim 6, wherein the characteristic dimension of the cavities is less than or equal to a minimum exfoliation radius determined by said statistical analysis.

**8.** Method according to one of claims 6 and 7, wherein a separation distance between contiguous cavities is such that the sum of the characteristic dimension of the cavities and of said separation distance is less than 100 $\mu$m.

**9.** Method according to claim 8, wherein said separation distance is greater than 1 $\mu$m.

**10.** Method according to claim 2, wherein the receiver substrate has a bevelled edge and wherein the region devoid of cavities (5, 6) at the rim of the bonding face emerges on said bevelled edge.

**11.** Method according to claim 2, wherein the receiver substrate has no bevelled edge and wherein the region devoid of cavities (5, 6) on the rim of the bonding face is present along the edge of the receiver substrate.

**12.** Substrate (3) comprising a bonding face (4) having open cavities (C), intended to serve as a receiver substrate in a method for transferring a semiconductor layer (2) from a donor substrate (1) having a weakening plane (F) to the receiver substrate, said method comprising the implementation, by putting the donor substrate and the bonding face of the receiver substrate in contact, of an assembly wherein said cavities are buried and the separation of the assembly by fracture along the weakening plane,
the bonding face having, apart from the open cavities, a bonding surface that comes into contact with the donor substrate when the assembly is implemented, said bonding surface comprising a region devoid of cavities (5, 6), one dimension of which is at least 100 $\mu$m and which has a surface area of at least 1 mm$^2$, and an intercavity space that occupies from 15 to 50% of the face of the receiver substrate.

**13.** Substrate according to claim 12, wherein said region devoid of cavities (5, 6) is at the rim of the bonding face of the receiver substrate.

**14.** Substrate according to claim 12, wherein said region devoid of cavities (5, 6) is at the centre of the bonding face of the receiver substrate.

**15.** Substrate according to one of claims 12 to 14, wherein the intercavity space occupies from 20 to 40% of the bonding face of the receiver substrate.

FIG. 1

5

FIG. 2

6

FIG. 3

FIG. 4

FIG. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014206737 A1

**Littérature non-brevet citée dans la description**

- **C-H YUN ; N.W.CHEUNG.** Fabrication of Silicon and Oxide Membranes Over Cavities Using Ion-Cut Layer Transfer. *Journal of Microelectromechanical Systems,* Décembre 2000, vol. 9 (4